Europäisches Patentamt

European Patent Office

Office européen des brevets

(19)

(11)  **EP 1 230 555 B1**

(12)  **EUROPÄISCHE PATENTSCHRIFT**

(45) Veröffentlichungstag und Bekanntmachung des Hinweises auf die Patenterteilung:
**04.06.2003  Patentblatt 2003/23**

(21) Anmeldenummer: 00958498.8

(22) Anmeldetag: **25.08.2000**

(51) Int Cl.⁷: $G01R\ 21/10$, $G01R\ 19/02$

(86) Internationale Anmeldenummer:
**PCT/EP00/08309**

(87) Internationale Veröffentlichungsnummer:
**WO 01/036988 (25.05.2001 Gazette 2001/21)**

(54) **ANORDNUNG ZUM MESSEN DES EFFEKTIVWERTES EINER WECHSELSPANNUNG ÜBER EINEN GROSSEN DYNAMIKBEREICH, INSBESONDERE ZUM MESSEN DER ELEKTRISCHEN LEISTUNG**

ARRANGEMENT FOR MEASURING THE ROOT MEAN SQUARE OF A POWER FREQUENCY VOLTAGE ACROSS A LARGE DYNAMIC RANGE, ESPECIALLY FOR MEASURING ELECTRICAL OUTPUT

DISPOSITIF DE MESURE DE LA VALEUR REELLE D'UNE TENSION ALTERNATIVE SUR UNE GRANDE PLAGE DYNAMIQUE, NOTAMMENT DE MESURE DE LA PUISSANCE ELECTRIQUE

(84) Benannte Vertragsstaaten:
**DE FR GB IT**

(30) Priorität: **17.11.1999  DE 19955342**

(43) Veröffentlichungstag der Anmeldung:
**14.08.2002  Patentblatt 2002/33**

(73) Patentinhaber: **Rohde & Schwarz GmbH & Co. KG D-81671 München (DE)**

(72) Erfinder:
• **REICHEL, Thomas 85598 Baldham (DE)**

• **BRATFISCH, Toralf 81929 München (DE)**

(74) Vertreter: **Körfer, Thomas, Dipl.-Phys. et al Mitscherlich & Partner, Patent- und Rechtsanwälte, Sonnenstrasse 33 80331 München (DE)**

(56) Entgegenhaltungen:
**EP-A- 0 320 265        US-A- 4 873 484 US-A- 4 876 654**

**Beschreibung**

Die Erfindung betrifft und geht aus von einer Anordnung laut Oberbegriff des Anspruchs 1.

Anordnungen dieser Art sind bekannt (US-Patentschriften 4 873 484 und 4 943 764). Der große Dynamikbereich wird auf zwei oder mehr Diodengleichrichter aufgeteilt, wobei die Ausgangsspannung jedes einzelnen Diodengleichrichters nur dann ausgewertet wird, wenn dieser in einem nutzbaren Abschnitt seines quadratischen Kennlinienbereiches arbeitet. Die Ausgangsspannungen der Diodengleichrichter werden über einen Meßbereichsumschalter einer einzigen Auswertschaltung zugeführt, d.h. es wird immer nur die Ausgangsspannung eines einzigen Diodengleichrichters ausgewertet. Wenn bei sprunghaften Änderungen der Meßgröße oder durch Modulation der nutzbare Kennlinienabschnitt des gerade wirksamen Diodengleichrichters verlassen wird, erzwingt dies den Abbruch der laufenden Messung, das Umschalten auf einen günstigen, d.h. im nutzbaren Kennlinienbereich arbeitenden Diodengleichrichter, das Abwarten der Einschwingzeit der Auswertschaltung und das Starten einer neuen Messung. Dadurch wird besonders die Beobachtung von einmaligen (transienten) Vorgängen, die nicht vom Dynamikbereich eines einzigen Diodengleichrichters abgedeckt werden, erschwert oder unmöglich gemacht. Besonders bei Hochfrequenzsignalen mit zeitlich veränderlicher Hüllkurvenleistung, bei denen das Verhältnis zwischen Maximalwert und Durchschnittswert der Hüllkurvenleistung sehr groß ist, haben solche bekannte, mit Bereichsumschaltung arbeitende Verfahren den Nachteil, daß der Meßbereich so gewählt werden muß, daß einzelne kurzzeitige Leistungsspitzen die Schaltung nicht übersteuern. Dies führt jedoch dazu, daß die Schaltung die meiste Zeit nur gering ausgesteuert ist und so der Signal-Rausch-Abstand gering ist.

Es ist Aufgabe der Erfindung, eine solche Anordnung zum Messen des Effektivwertes einer Spannung über einen großen Dynamikbereich zu schaffen, bei der diese Nachteile vermieden werden und die auch bei zeitlich veränderlicher Hüllkurvenleistung, beispielsweise infolge sprunghafter Änderungen der Meßgröße oder durch Modulation, eine genaue fehlerfreie Messung ermöglicht.

Diese Aufgabe wird ausgehend von einer Anordnung laut Oberbegriff des Hauptanspruches durch dessen kennzeichnende Merkmale gelöst. Vorteilhafte Weiterbildungen ergeben sich aus den Unteransprüchen.

Bei der erfindungsgemäßen Anordnung wird ein Umschalter vermieden und für jeden Diodengleichrichter ein gesonderter Kanal für die Aufbereitung der durch die Diodengleichrichter gemessenen Teilspannungen vorgesehen. Unter Teilspannung wird dabei sowohl der Bruchteil als auch ein Vielfaches der zu messenden Eingangsspannung verstanden. In jedem Kanal erfolgt eine gesonderte Analog-Digital-Wandlung mit anschließender digitaler Signalverarbeitung. Bei Einsatz sehr schneller A/D-Wandler könnte die Digitalisierung der separaten Kanäle auch nacheinander erfolgen, d.h. es genügt in diesen Fällen nur ein einziger A/D-Wandler, wobei sich der Signalverarbeitungsweg unmittelbar nach diesem A/D-Wandler wieder in zwei gesonderte Zweige aufspaltet. Die Digitalwerte aller Kanäle werden entsprechend ihrem Informationsgehalt entsprechend gewichtet und skaliert. Die Summe der Wichtungsfaktoren ist dabei eins. Die einzelnen Wichtungsfaktoren bzw. deren Verhältnis ist vom Aussteuerungsgrad mindestens eines der Diodengleichrichter abgeleitet. Der Meßkanal für die höheren Leistungen wird beispielsweise an der Untergrenze seines Meßbereiches Meßergebnisse liefern, die größere Meßunsicherheiten aufweisen als im empfindlicheren Meßkanal. Mit größer werdender Leistung werden sich die Verhältnisse umkehren, beispielsweise durch Übersteuerungseffekte im empfindlicheren Meßkanal. Je nach dem Zusammenhang zwischen Meßunsicherheit und Leistung werden daher im Sinne der Unteransprüche unterschiedliche Wichtungsfunktionen benutzt. Damit die Ergebnisse der einzelnen Kanäle anschließend zu einem Ausgangswert summiert werden können, müssen die gewichteten Digitalwerte der einzelnen Kanäle noch entsprechend so skaliert werden, daß sie sich als Bruchteil oder als Vielfaches einer gemeinsamen Quantisierungseinheit darstellen lassen.

Eine erfindungsgemäße Anordnung eignet sich nicht nur zum genauen Messen von Hochfrequenzsignalen mit zeitlich konstanter Hüllkurvenleistung (CW-Signale), sondern vor allem auch zum genauen Messen von Hochfrequenzsignalen mit zeitlich veränderlicher Hüllkurvenleistung, wie dies beispielsweise bei modulierten Hochfrequenzsignalen der Fall ist. Bei der erfindungsgemäßen Anordnung wird nämlich für jeden einzelnen Abtastwert der A/D-Wandler durch Wichtung und Skalierung des entsprechenden Digitalwertes ein Meßwert gewonnen.

Eine erfindungsgemäße Anordnung zum Messen des Effektivwertes einer Wechselspannung über einen großen Dynamikbereich ist nicht nur zum Messen der elektrischen Leistung von beispielsweise Hochfrequenzsignalen geeignet, sondern auch zum Messen des Effektivwertes bzw. des quadratischen Mittelwertes von beliebigen anderen physikalischen Größen über einen großen Dynamikbereich, die durch entsprechende Wandler in eine Spannung umgesetzt werden, wie dies beispielsweise bei der Messung von mechanischen Spannungen durch Meßwandler od.dgl. der Fall ist. Auch hier kann in gleicher Weise die erfindungsgemäße Anordnung benutzt werden.

Die Erfindung wird im Folgenden anhand schematischer Zeichnungen an einem Ausführungsbeispiel näher erläutert.

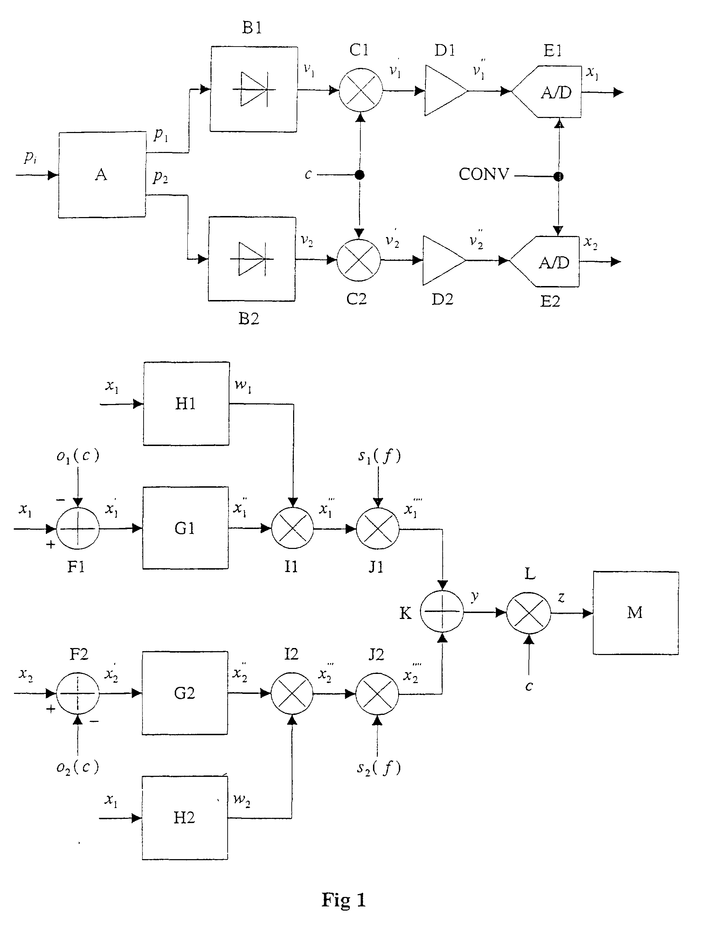

Figur 1 zeigt das Prinzipschaltbild einer erfindungsgemäßen Schaltung zum Messen der elektrischen Leistung eines Hochfrequenzsignals über einen großen Dynamikbereich.

Das Hochfrequenzsignal mit der zu bestimmenden Leistung $p_i$ wird zur Aufteilung des Dynamikbereiches zunächst dem linearen Netzwerk A zugeführt, welches durch geeignet angeordnete Teiler, Abschwächer oder Verstärker zwei Hochfrequenzsignale mit unterschiedlicher, zu $p_i$ proportionaler Leistung $p_1$ bzw. $p_2$ erzeugt. Die Leistungen $p_1$ und $p_2$ seien im Verhältnis zueinander so bemessen, daß sich die nutzbaren Kennlinienbereiche der beiden Diodengleichrichter B1 und B2 teilweise überdecken, d. h. es gibt einen Übergangsbereich, in dem sowohl B1 als auch B2 gültige Ergebnisse liefert. Dabei gelte stets die Relation $p_1 > > p_2$, d. h. Kanal 1 sei bei identischem Aufbau beider Kanäle wesentlich empfindlicher für $p_i$ als Kanal 2.

Die beiden erzeugten Hochfrequenzsignale werden mittels der Diodengleichrichter B1 und B2 gleichgerichtet. Da B1 und B2 im quadratischen Bereich betrieben werden, sind ihre Ausgangs-spannungen $v_1$ und $v_2$ proportional zu $p_1$ bzw. $p_2$. Mit Hilfe der Chopper (Zerhacker) C1 und C2 werden die Gleichspannungen $v_1$ und $v_2$ in die Wechselspannungen $v_1'$ und $v_2'$ umgeformt, um eine Beeinträchtigung des Meßergebnisses durch die Offsetspannungsdriften der Verstärker D1 und D2 sowie die Nullpunktdriften der Analog-Digital-Wandler E1 und E2 zu verhindern. Dieser Vorganglätt sich als Multiplikation mit einer Variablen $c$, die abwechselnd die Werte +1 und -1 annimmt, verstehen.

Die Wechselspannungen $v_1'$ und $v_2'$ werden mit den Verstärkern D1 bzw. D2 verstärkt. Die verstärkten Wechselspannungen $v_1''$ und $v_2''$ werden anschließend mit den Analog-Digital-Wandlern E1 und E2 in die Digitalwerte $x_1$ bzw. $x_2$ umgewandelt. Analog-Digital-Wandlungen werden bei E1 und E2 gleichzeitig durch das gemeinsame Steuersignal CONV ausgelöst.

Die Digitalwerte $x_1$ und $x_2$ sind mit Offsets behaftet, d.h. trotz eines linearen Zusammenhangs mit $p_1$ bzw. $p_2$ sind sie nicht proportional zu $p_1$ bzw. $p_2$. Erst nach einer Offsetkorrektur, bei der die Offsets $o_1$ und $o_2$ mit Hilfe der Summierer F1 und F2 von $x_1$ bzw. $x_2$ subtrahiert werden, erhält man wieder zu $p_1$ bzw. $p_2$ proportionale Digitalwerte $x_1'$ bzw. $x_2'$. Die Offsets können für beide Schaltzustände der Chopper unterschiedlich sein (z. B. aufgrund von Thermospannungen, die ihren Ursprung im Diodengleichrichter haben). Sie werden vor der Messung für beide Schaltzustände der Chopper ($c$ = +1 und $c$ = -1) durch Messung von $x_1$ bzw. $x_2$ für $p_i$ = 0 ermittelt und gespeichert.

Die Funktionsblöcke G1 und G2 dienen, soweit notwendig, zur Linearisierung der Schaltungskennlinie. In der vorliegenden Anwendung besteht schon eine lineare Abhängigkeit der Ausgangsspannung der einzelnen Diodengleichrichter von der ihnen zugeführten Leistung. Da alle sonstigen Schaltungskomponenten ebenfalls ein lineares Verhalten zeigen, können G1 und G2 im Idealfall entfallen. Oft wird jedoch der Wunsch bestehen, die Diodengleichrichter B1 und B2 über die Obergrenze des quadratischen Bereichs hinaus auszusteuern. Die daraus resultierenden Linearitätsabweichungen lassen sich mit G1 und G2 korrigieren, um einen größeren nutzbaren Kennlinienbereich zu erhalten. Allerdings ist zu beachten, daß bei Aussteuerung der Diodengleichrichter über die Obergrenze des quadratischen Bereichs hinaus im Hochfrequenzsignal enthaltene Oberwellen höhere Meßunsicherheiten verursachen.

Soll mit der beschriebenen Schaltung nicht die Leistung, sondern der Spannungs-Effektivwert eines Hochfrequenzsignals ermittelt werden, so können G1 und G2 dazu benutzt werden, die quadratische Abhängigkeit der Ausgangsspannung der einzelnen Diodengleichrichter von ihrer Eingangsspannung zu kompensieren, d. h. sie dienen in diesem Fall zur Berechnung der Funktion $x''_1 = \sqrt{x'_1}$ bzw $x_2'' = \sqrt{x'_2}$. Weitere konkrete Anwendungen für G1 und G2 ergeben sich bei Verwendung anderer Meßwandler mit nichtlinearer Kennlinie, um z. B andere physikalische Größen zu messen als die Leistung oder den Spannungs-Effektivwert eines Hochfrequenzsignals.

Nach der Linearisierung werden die Digitalwerte $x_1''$ und $x_2''$ entsprechend ihrem Informationsgehalt gewichtet, indem sie mittels der Multiplizierer H1 und H2 mit den Wichtungsfakto-ren $w_1$ und $w_2$ multipliziert werden. Diese Wichtungsfaktoren werden in den Funktionsblöcken H1 und H2 generiert Als Maß für den Informationsgehalt kann man beispielsweise den Grad der Aussteuerung des Analog-Digital-Wandlers E1 heranziehen:

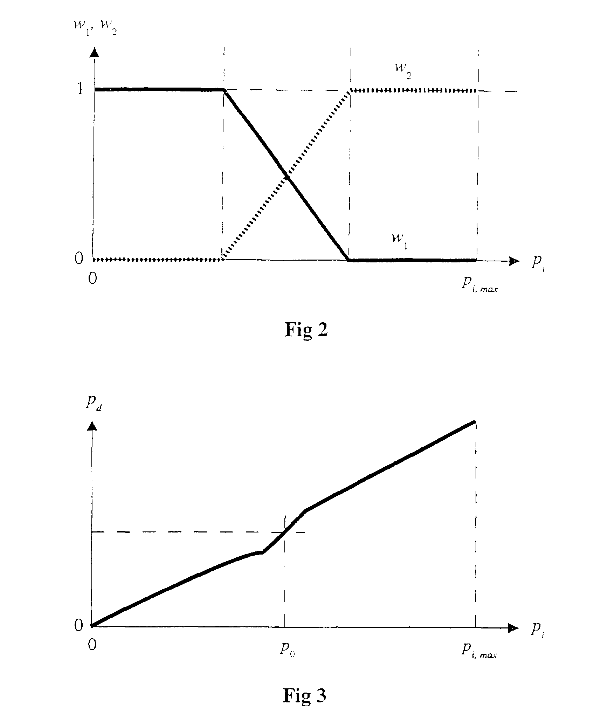

Ist E1 z. B. weniger als zur Hälfte positiv oder negativ ausgesteuert, dann kann man davon ausgehen, daß die Aussteuerung von E2 noch viel geringer ist (der Kanal 2 wurde als wesentlich unempfindlicher als Kanal 1 vorausgesetzt). Die Ergebnisse von Kanal 2 haben dann einen schlechten Signal-Rausch-Abstand, weshalb ihr Informationsgehalt als niedrig anzusehen ist. In diesem Fall ist $w_1$ = 1 und $w_2$ = 0 (Figur 2). Die Ergebnisse von Kanal 2 werden verworfen, die Ergebnisse von Kanal 1 zu 100 % weiterverarbeitet.

Ist E1 z. B. mindestens zur Hälfte, aber noch nicht voll positiv oder negativ ausgesteuert, liefert sowohl Kanal 1 als auch Kanal 2 gültige Ergebnisse. Die Wichtung von Kanal 1 nimmt mit zunehmender Aussteuerung von E1 allmählich ab. Dagegen nimmt die Wichtung von Kanal 2 allmählich zu. Die Summe aller Wichtungfaktoren muß stets 1 betragen.

Ist E1 maximal positiv oder negativ ausgesteuert, haben die Ergebnisse von Kanal 1 einen niedrigen Informationsgehalt, weil bei weiterer Aussteuerung (Übersteuerung) der ausgegebene Digitalwert nicht mehr größer werden kann (Clipping). Folglich ist $w_1$ = 0 und $w_2$ = 1. Es ist technisch sinnvoll, in jedem Kanal die Vollaussteuerung des Analog-Digital-Wandlers auf die Obergrenze des nutzbaren Kennlinienbereiches des Diodengleichrichters abzustimmen.

Die gewichteten Digitalwerte $x_1'''$ und $x_2'''$ sind Vielfache unterschiedlicher Quantisierungseinheiten, d.

h. gleiche Digitalwerte repräsentieren in Kanal 2 eine andere Leistung als in Kanal 1. Dies ist zum einen die Auswirkung des Netzwerkes A, zum anderen der unterschiedlichen Verstärkung von D1 und D2 und der unterschiedlichen Empfindlichkeit von B1, B2, E1 und E2 (auch bei völlig gleicher Dimensionierung lassen sich Toleranzen niemals ganz vermei-den). Durch die Multiplikation mit den Skalierfaktoren $s_1$ und $s_2$ mit Hilfe der Multiplizierer J1 und J2 werden diese Auswirkungen kompensiert. Die Skalierfaktoren $s_1$ und $s_2$ sind z.B. abhängig von der Trägerfrequenz des Hochfrequenzsignals. Sie werden durch einen Kalibriervorgang ermittelt und gespeichert. Die Digitalwerte $x_1''''$ und $x_2''''$ sind Vielfache oder Bruchteile derselben Quantisierungseinheit, d. h. gleiche Digitalwerte repräsentieren gleiche Leistungen. Mit Hilfe des Summierers K werden sie addiert.

Der Synchrondemodulator L macht die Wirkung der Chopper (Zerhacker) C1 und C2 rückgängig. Dies geschieht durch die Multiplikation von $y$ mit der Variablen $c$. Der Digitalwert $y$ enthält durch den Einfluß der Chopper bereits den Faktor $c$. Der gleichgerichtete Digitalwert $z$ ist idealerweise unabhängig von $c$, denn er enthält diesen Faktor zweimal, was zu dessen Kompensation führt ($1 \cdot 1 = 1$ und $-1 \cdot -1 = 1$). Praktisch wird jedoch die weiter oben angesprochene Offsetkorrektur mittels F1 und F2 niemals vollständig gelingen: Die wahren Offsets können sich z. B. durch Temperaturschwankungen ständig ändern. Die Summierer F1 und F2 subtrahieren aber nur die Offsets, die zu einem bestimmten Zeitpunkt ermittelt und abgespeichert wurden. Alle Offset-Anteile, die in der Schaltung nach C1 und C2 entstehen, werden jedoch nur einmal mit $c$ multipliziert, d. h. sie werden durch L in Wechselspannungen umgewandelt. Niederfrequentes Rauschen von D1, D2, E1 und E2, dessen Frequenz unter der Chopperfrequenz liegt, wird durch die Synchrondemodulation mit der Chopperfrequenz gemischt und dadurch spektral so verändert, daß eine spätere Rauschunterdrückung durch digitale Filterung erleichtert oder überhaupt erst ermöglicht wird.

Der erhaltene Digitalwert $z$ ist über einen großen Dynamikbereich proportional zur zu messenden Leistung $p_i$ des Hochfrequenzsignals. Er kann auf konventionelle Weise weiterverarbeitetwerden. Dazu dient der Schaltungsblock M, der z. B. die digitale Filterung der Meßwerte, die Kompensation des Temperaturgangs, die Berechnung des Spannungs-Effektivwertes, Steuerungsfunktionen und die Meßwertanzeige enthält.

Wie bereits erwähnt, weist die Kennlinie einer erfindungsgemäßen Schaltung keine Sprünge und Hystereseeffekte auf. So ist sichergestellt, daß einer bestimmten Leistung $p_i = p_o$ stets ein eindeutiger angezeigter Leistungswert $p_d$ zugeordnet wird (Figur 3).

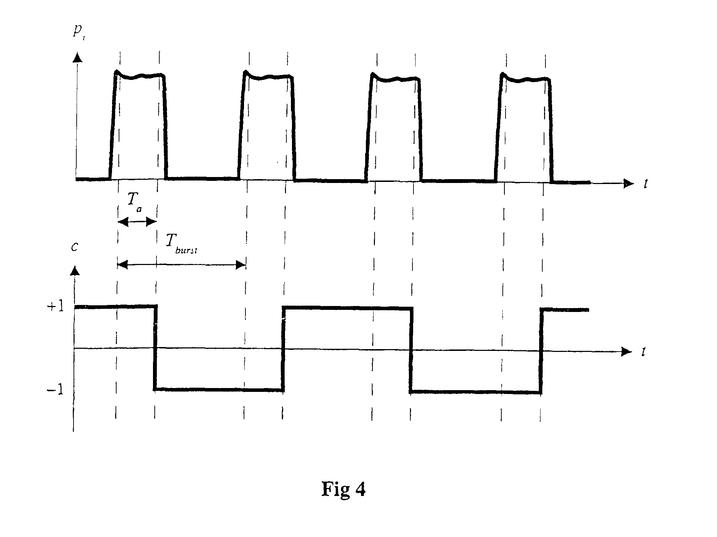

Die genaue Funktion des Choppers und des Synchrondemodulators läßt sich aus Figur 4 ableiten. Dort ist für ein Beispiel der zeitliche Verlauf der Variablen $c$ dargestellt. Die Meßaufgabe besteht darin, die mittlere Burstleistung des im oberen Diagramm abgebildeten Signals zu ermitteln. Dazu werden, gesteuert durch eine Triggerschaltung, Meßdaten nur innerhalb der Meßzeiträume mit der Dauer $T_a$ (Aperturzeit) erfaßt und gemittelt. Je Meßzeitraum erhält man einen Leistungsmittelwert $P_v$. Jeweils am Ende des Meßzeitraums ändert sich das Vorzeichen von $c$. Die Zeit bis zum Beginn eines neuen Meßzeitraums muß ausreichend groß sein, daß Einschwingvorgänge in der Schaltung abklingen können. Erfaßt wird stets eine gerade Anzahl von Leistungsmittelwerten $P_v$. Dadurch ist sichergestellt, daß ein störender Offset, der in der Schaltung nach den Choppern entsteht und von F1 bzw. F2 nicht vollständig korrigiert wird, in genau so vielen $P_v$ mit positivem Vorzeichen auftritt wie mit negativem Vorzeichen. Bildet man den arithmetischen Mittelwert aller $P_v$, wird dieser Offset vollständig kompensiert. Als Ergebnis der Mittelwertbildung erhält man den eigentlichen Meßwert $P$.

Im o. g. Beispiel liegt zwischen zwei Vorzeichenänderungen von $c$ die Zeit $T_{burst}$, welche die Periodendauer der Signalbursts angibt. Damit ist die Chopperfrequenz $1 / (2\ T_{burst})$.

Werden die Aperturzeit und die Chopperfrequenz nicht von der Meßaufgabe vorgegeben, so wählt eine erfindungsgemäße Schaltung dafür automatisch sinnvolle Standardwerte.

Selbstverständlich läßt sich in einer Schaltung, wie sie in Figur 1 dargestellt ist, die Art und Anordnung der Funktionsblöcke variieren. Aufgrund ihres linearen Charakters kann man z.B. die Reihenfolge von Multiplizierern vertauschen oder die Synchrondemodulation vor die Summation verschieben. Ebenso ist die dargestellte Aufteilung in analoge und digitale Funkti-onsblökke lediglich als technisch sinnvoll, keinesfalls als einschränkend zu verstehen. So ist es beispielsweise denkbar, die Offsetkorrektur in den analogen Teil der Schaltung zu verlegen.

**Patentansprüche**

1. Anordnung zum Messen des Effektivwertes einer Wechselspannung über einen großen Dynamikbereich, insbesondere zum Messen der elektrischen Leistung, bei der die zu messende Spannung in zwei oder mehrere dazu proportionale Teilspannungen umgesetzt und jede Teilspannung mittels eines eigenen Diodengleichrichters (B1, B2) gemessen wird,

   **dadurch gekennzeichnet,**

   **daß** die Ausgangsspannungen der Diodengleichrichter (B1, B2) in einen Digitalwert umgesetzt werden, jeder dieser Digitalwerte mit Wichtungsfaktoren (w1, w2) gewichtet wird, deren Verhältnis vom Aussteuerungsgrad mindestens eines der Diodengleichrichter (B1, B2) abgeleitet wird, und diese gewichteten Digitalwerte nach Skalierung auf eine gemeinsame Quantisierungseinheit zum eigentlichen digitalen Meßwert summiert werden.

2. Anordnung nach Anspruch 1,
**dadurch gekennzeichnet,**
**daß** die Summe der Wichtungsfaktoren eins ist.

3. Anordnung nach Anspruch 1 oder 2,
**dadurch gekennzeichnet,**
**daß** die Digitalisierung der Ausgangsspannungen jeweils mittels gesonderter A/D-Wandler erfolgt.

4. Anordnung nach einem der vorhergehenden Ansprüche,
**dadurch gekennzeichnet,**
**daß** die Skalierungsfaktoren (s1, s2) durch einen Kalibriervorgang ermittelt werden.

5. Anordnung nach einem der vorhergehenden Ansprüche,
**dadurch gekennzeichnet,**
**daß** der oder die A/D-Wandler vom abtastenden Typ sind und für jeden Abtastwert die Wichtung und Skalierung der Digitalwerte durchgeführt wird.

6. Anordnung nach einem der vorhergehenden Ansprüche,
**dadurch gekennzeichnet,**
**daß** zwischen den Wichtungsfaktoren (w1, w2) und dem digitalen Ausgangswert von einem der A/D-Wandler ein durch ein Polynom bestimmter Zusammenhang besteht.

7. Anordnung nach Anspruch 6,
**dadurch gekennzeichnet,**
**daß** ein linearer Zusammenhang besteht.

8. Anordnung nach einem der vorhergehenden Ansprüche 1 bis 5,
**dadurch gekennzeichnet,**
**daß** zwischen den Wichtungsfaktoren und dem Ausgang von einem der A/D-Wandler ein durch einen stückweise linearen Funktionsverlauf bestimmter Zusammenhang besteht.

9. Anordnung nach einem der vorhergehenden Ansprüche 1 bis 5,
**dadurch gekennzeichnet,**
**daß** zwischen den Wichtungsfaktoren und dem Ausgang von einem der A/D-Wandler ein durch eine harmonische Funktion bestimmter Zusammenhang besteht.

10. Anordnung nach einem der vorhergehenden Ansprüche,
**dadurch gekennzeichnet,**
**daß** die Ausgangsspannung jedes Diodengleichrichters mittels eines Choppers in eine Wechselspannung umgesetzt und nach Verstärkung und Digitalisierung durch Synchrondemodulation wieder rückumgesetzt wird, wobei die Umschaltzeitpunkte des Choppers und Synchrondemodulators so mit dem Meßvorgang synchronisiert sind, daß die Umschaltzeitpunkte jeweils außerhalb der Meßzeiträume liegen (Figur 4).

11. Anordnung nach Anspruch 10,
**dadurch gekennzeichnet,**
**daß** der Beginn der Meßzeiträume durch ein aus dem Meßsignal abgeleitetes oder extern bereitgestelltes Triggersignal und die Dauer der Meßzeiträume durch eine frei wählbare oder aus dem Meßsignal abgeleitete Aperturzeit bestimmt ist und Chopper und Synchrondemodulator sich abwechselnd für eine Periode des Meßsignals im nicht invertierenden bzw. invertierenden Zustand befinden.

12. Anordnung nach einem der vorhergehenden Ansprüche,
**dadurch gekennzeichnet,**
**daß** die Digitalwerte vor Wichtung und Skalierung bezüglich ihres Offsets korrigiert und/oder linearisiert werden.

13. Anordnung nach einem der vorhergehenden Ansprüche,
**dadurch gekennzeichnet,**
**daß** die Ausgangsspannungen der Diodengleichrichter (B1, B2) jeweils in proportionale Digitalwerte umgesetzt werden.

**Claims**

1. Arrangement to measure the r.m.s. value of an alternating voltage over a large dynamic range, in particular to measure the electrical power, in which the voltage to be measured is divided into two or more partial voltages which are proportional to it, and each partial voltage is measured by its own diode rectifier (B1, B2),
**characterized in that**
the output voltages of the diode rectifiers (B1, B2) are converted into a digital value, each of these digital values is weighted with weighting factors (w1, w2), the ratio of which is derived from the drive factor of at least one of the diode rectifiers (B1, B2), and these weighted digital values are summed to the actual digital measured value after scaling to a common quantisation unit.

2. Arrangement according to Claim 1,
**characterized in that**
the sum of the weighting factors is one.

3. Arrangement according to Claim 1 or 2,

**characterized in that**
the output voltages are each digitised by separate A/D converters.

4. Arrangement according to one of the preceding claims,
**characterized in that**
the scaling factors (s1, s2) are determined by a calibration process.

5. Arrangement according to one of the preceding claims,
**characterized in that**
the A/D converter(s) is/are of scanning type, and the digital values are weighted and scaled for each scanned value.

6. Arrangement according to one of the preceding claims,
**characterized in that**
there is a relationship which is determined by a polynomial between the weighting factors (w1, w2) and the digital output value of one of the A/D converters.

7. Arrangement according to Claim 6,
**characterized in that**
there is a linear relationship.

8. Arrangement according to one of the preceding Claims 1 to 5,
**characterized in that**
there is a relationship which is determined by a partially linear function course between the weighting factors and the output of one of the A/D converters.

9. Arrangement according to one of the preceding Claims 1 to 5,
**characterized in that**
there is a relationship which is determined by a harmonic function between the weighting factors and the output of one of the A/D converters.

10. Arrangement according to one of the preceding claims,
**characterized in that**
the output voltage of each diode rectifier is converted by a chopper into an alternating voltage, and after amplification and digitisation it is converted back by synchronous demodulation, the switching times of the chopper and synchronous demodulator being synchronised with the measurement process so that the switching times are outside the measurement periods (Fig. 4).

11. Arrangement according to Claim 10,
**characterized in that**
the start of the measurement periods is determined by a trigger signal which is derived from the measurement signal or provided externally, and the duration of the measurement periods is determined by a freely selectable aperture time or one which is derived from the measurement signal, and the chopper and synchronous demodulator are alternately in the non-inverting and inverting state for a period of the measurement signal.

12. Arrangement according to one of the preceding claims,
**characterized in that**
before weighting and scaling, the digital values are corrected and/or linearised with respect to their offset.

13. Arrangement according to one of the preceding claims,
**characterized in that**
the output voltages of the diode rectifiers (B1, B2) are each converted into proportional digital values.

**Revendications**

1. Dispositif de mesure de la valeur efficace d'une tension alternative sur une grande plage dynamique, notamment de mesure de la puissance électrique, dans lequel la tension à mesurer est convertie en deux ou plusieurs tensions partielles proportionnelles à la tension à mesurer et dans lequel on mesure chacune des tensions partielles au moyen d'un redresseur à diodes (B1, B2) respectif,
**caractérisé en ce que**,
les tensions de sortie des redresseurs à diodes (B1, B2) sont converties en une valeur numérique, **en ce que** chacune de ces valeurs numériques est pondérée à l'aide de facteurs de pondération (w1, w2) dont le rapport est déduit du coefficient de modulation d'au moins un des redresseurs à diodes (B1, B2) et **en ce que** ces valeurs numériques pondérées sont additionnées, après mise à l'échelle, en une unité de quantification commune qui permet d'obtenir la valeur numérique de mesure proprement dite.

2. Dispositif selon la revendication 1,
**caractérisé en ce que**
la somme des facteurs de pondération est égale à un.

3. Dispositif selon la revendication 1 ou 2,
**caractérisé en ce que**
la numérisation des tensions de sortie s'effectue dans chaque cas au moyen d'un transformateur A/N distinct.

4. Dispositif selon l'une quelconque des revendications précédentes,

**caractérisé en ce que**
les facteurs de mise à l'échelle (s1, s2) sont déterminés par un procédé de calibrage.

5. Dispositif selon l'une quelconque des revendications précédentes,
**caractérisé en ce que**
le ou les transformateurs sont de type à échantillonnage et **en ce que** l'on effectue la pondération et la mise à l'échelle des valeurs numériques pour chaque échantillon.

6. Dispositif selon l'une quelconque des revendications précédentes,
**caractérisé en ce qu'**il
existe une relation déterminée par un polynôme entre les facteurs de pondération (w1, w2) et la valeur numérique de sortie de l'un des transformateurs A/N.

7. Dispositif selon la revendication 6,
caractérisé en qu'il
existe une relation linéaire.

8. Dispositif selon l'une quelconque des revendications précédentes 1 à 5,
**caractérisé en ce qu'**il
existe une relation déterminée par une variation d'une fonction linéaire par morceaux entre les facteurs de pondération et la sortie de l'un des transformateurs A/N.

9. Dispositif selon l'une quelconque des revendications précédentes 1 à 5,
**caractérisé en ce qu'**il
existe une relation déterminée par une fonction harmonique entre les facteurs de pondération et la sortie de l'un des transformateurs A/N.

10. Dispositif selon l'une quelconque des revendications précédentes,
**caractérisé en ce que**
la tension de sortie de chaque redresseur à diodes est convertie en tension alternative au moyen d'un chopper, puis de nouveau reconvertie, après amplification et numérisation, par démodulation synchrone, où les instants de commutation du chopper et du démodulateur synchrone sont synchronisés avec le procédé de mesure de sorte que les instants de commutation se trouvent chaque fois en dehors des intervalles de temps de mesure (figure 4).

11. Dispositif selon la revendication 10,
**caractérisé en ce que**
l'on détermine le début de l'intervalle de temps de mesure à l'aide d'un signal de déclenchement, déduit du signal de mesure ou affecté de l'extérieur, et la durée de l'intervalle de temps de mesure à l'aide d'un temps d'ouverture, déduit du signal de mesure ou à choisir librement, et **en ce que**, pour une période du signal de mesure, le chopper et le démodulateur synchrone se trouvent, à tour de rôle, à l'état non inversant ou, respectivement, inversant.

12. Dispositif selon l'un quelconque des revendications précédentes,
**caractérisé en ce que**
les valeurs numériques sont corrigées et/ou linéarisées compte tenu de leur décalage, préalablement à la pondération et à la mise à l'échelle.

13. Dispositif selon l'un quelconque des revendications précédentes,
**caractérisé en ce que**
les tensions de sortie des redresseurs à diodes (B1, B2) sont dans chaque cas converties en valeurs numériques proportionnelles.

Fig 1

**Fig 2**

**Fig 3**

Fig 4